# EUROPÄISCHE PATENTANMELDUNG

(11) **EP 1 471 569 A1**
(43) Veröffentlichungstag der Anmeldung: **27.10.2004**
(21) Anmeldenummer: 04008523.5
(22) Anmeldetag: 08.04.2004
(51) Int. Cl.: H01L 21/48, H01L 23/498, H01L 21/60

(54) **Verfahren zum Trennen der elektrischen Verbindungsknoten bei IC-Frames und Verfahren zur Herstellung eines elektronischen Bauteils sowie von Frames dafür**

(30) Priorität: 24.04.2003 DE 10318688
(71) Anmelder: W.C. Heraeus GmbH & Co. KG, 63450 Hanau (DE)
(72) Erfinder: Hartmann, Horst, 63454 Hanau (DE); Kolodzei, Günter, 63791 Karlstein (DE)
(74) Vertreter: Kühn, Hans-Christian

(57) **Zusammenfassung**

Verfahren zum Trennen der elektrischen Verbindungen bei auf langen Endlosbändern aus Kunststofffolie laminierten IC-Frames, dadurch gekennzeichnet, dass die Folienverbundbänder an den Metallkontaktstellen so durchtrennt werden, dass die Metallfolie in ihrer gesamten Stärke, nicht aber die Kunststofffolie durchtrennt wird, sowie Verfahren zur Herstellung und gegebenenfalls Prüfung eines elektronischen Bauteils (Moduls).

## Beschreibung

Die Erfindung betrifft ein Verfahren zum Trennen der elektrischen Verbindungsknoten bei elektronischen Bauteilen, insbesondere IC-Kontakt-Frames, sowie Verfahren zur Herstellung und gegebenenfalls Prüfung eines elektronischen Bauteils sowie von Frames dafür.

Bei Herstellung von der Chipkarten oder ähnlichen Produkten mit Trägerbändern nach der Stanz-Laminiertechnik wird ein Metallband mit den Kontakt-Frames für die integrierten Schaltkreise (Chips) in der Regel auf langen Endlosbändern aus Kunststofffolie laminiert. Die Metallframes müssen während des Laminiervorgangs formstabil bleiben, was relativ breite und starke Verbindungen (Brücken) zum Randbereich des Metallfolienbandes nötig macht. Diejenigen Brücken, die für die elektrische Funktion nicht erforderlich sind und Kurzschlüsse bilden, müssen später getrennt werden. Die Trennung erfolgt heute normalerweise durch Stanzen.

Nachteilig dabei ist, dass beim Stanzen die Kunststofffolie mit durchtrennt wird und sogenannte Freistanzlöcher entstehen. Diese können sich in sensiblen Zonen befinden, etwa dort, wo auch der Einspritzkanal für die Plastikmasse der Moldkörper liegt. Die Plastikmasse verankert sich unerwünschterweise regelmäßig in den Freistanzlöchern und haftet besonders an rauhen Abrissstellen der Stanzränder, und die Angussmasse kann anschließend nur mit Schwierigkeiten entfernt werden. Im Folgenden wird die Plastikmasse als Gussmasse, Vergussmasse oder Angussmasse bezeichnet. Es kann sich aber auch um eine andere Plastikmasse, etwa eine Spritzmasse handeln.

Es ist auch möglich, dass die Freistanzlöcher im Bereich von Kontaktflächen zu liegen kommen, die nicht unterbrochen werden dürfen. Diese Kontaktflächen befinden sich auf der Rückseite, da die Bauteile aus drei Lagen bestehen: Frame, Isolierung und Kontaktflächen. Bei Anwendung des Stanzverfahrens würden die Kontakflächen mitgelocht und die gesamte Funktion zerstört. In solchen Fällen wurde bisher die sogenannte Ätz-Laminiertechnik angewandt. Das Ätzen der Metallkontaktmuster erfolgt dabei erst nach dem Laminieren, und die Kunststofffolie fungiert als Träger, so dass keine Anbindungen der Metallfolie zur Stabilisierung erforderlich sind.

Es besteht daher ein Bedürfnis, ein Verfahren zur Verfügung zu haben, bei dem die Freistanzlöcher keine Problem der oben geschilderten Art verursachen, und das die Anwendung der Stanz-Laminiertechnik auch in Fällen erlaubt, in denen bislang nur die Ätz-Laminiertechnik angewandt werden konnte.

Das Problem wird durch Verfahren nach den unabhängigen Ansprüchen gelöst. Vorteilhafte Ausführungsformen sind in den Unteransprüchen angegeben. Es wurde entsprechend gefunden, dass man die oben genannten Ziele überraschend elegant erreicht, indem man dafür sorgt, dass keine Freistanzlöcher mehr auftreten. Dazu wird das Stanzverfahren zur Metalltrennung gänzlich aufgegeben, und man trennt die Metallfolie im laminierten Zustand selektiv so, dass die Kunststofffolie nicht getrennt wird und folglich keine Freistanzlöcher entstehen. Dazu wird die Metallfolie mit z.B. einer geeigneten Fräs- oder Laserschneidmethode bearbeitet.

Bei dem Verfahren wird in der Regel ein Teil der Kunststofffolie mit angeschnitten.

Die Erfindung betrifft somit ein Verfahren zum selektiven Trennen der elektrischen Verbindungen, besonders Knoten, Brücken oder Stege, bei auf langen Endlosbändern aus Kunststofffolie laminierten IC-Frames, das sich dadurch auszeichnet, dass die Folienverbundbänder an den Metallkontaktstellen so durchtrennt werden, dass die Metallfolie in ihrer gesamten Stärke, nicht aber die Kunststofffolie durchtrennt wird. Die entsprechenden Laserschneid- oder Fräsmethoden sind dem Fachmann bekannt und sind z.B. zum Einbringen von Aussparungen zur Aufnahme von Gussmasse in Kunststofffolien empfohlen worden (DE 43 26 816 A1).

Ein Vorteil des Verfahrens liegt darin, daß die elektrischen Funktion des Chipmoduls später direkt auf dem Band getestet werden kann. Die Erfindung betrifft daher auch ein Verfahren zur Herstellung und gegebenenfalls Prüfung eines elektronischen Bauteils (Moduls) mit den Schritten A bis J bzw. A - K:
- A: Bereitstellen einer Metallfolie, bevorzugt in der Stärke 0,03 bis 0,2 mm,
- B: Stanzen der Metallfolie mit der Struktur des Systemträgers (Moduls) einschließlich der Pilot- oder Filmlöcher, der Verbindungsstege, der Brücken und der zentralen Verbindungskonten,

- C: Bereitstellen einer Kunststofffolie, bevorzugt in der Stärke 0,03 bis 0,2 mm,
- D: Passgenaues Stanzen der Kunststoff Durchbrüche für die Bauteilmontage, Kontaktierung z.B. der Bondlöcher oder Testlöcher sowie der Pilot-/Filmlöcher,
- E: Passgenaues Laminieren der gemäß B und D behandelten Metall und Kunststofffolie zu einem Folienverbundband;
- F: Elektrogalvanisches Beschichten des Laminates für die jeweilige Anwendung, z.B. mit Nickel, Silber, Palladium oder Gold (entspricht dem Aufbringen von Funktionsschichten);
- G: Trennen der elektrischen Verbindungen bei den auf langen Endlosbändern aus Kunststofffolie laminierten IC-Frames, wobei die Folienverbundbänder an den Metallkoritaktstellen so durchtrennt werden, dass die Metallfolie in ihrer gesamten Stärke, nicht aber die Kunststofffolie durchtrennt wird;
- H: Positionieren eines Halbleiter Bauelementes (Chips) im Chip-Positivbereich (Durchbruch der Kunststofffolie)
- I: Verbinden der Kontaktflächen des Chips mit den Bondlöchern
- J: Vergießen des Bauelements, sowie gegebenenfalls, wenn eine Prüfung durchgeführt werden soll:
- K: Testen der elektronischen Funktion

Bei Schritt G wird das selektive elektrische Trennen der Kontaktpads möglich und die Dichtheit der Kunststoffseite bleibt erhalten.

Das Verfahren wird bevorzugt ab dem Schritt H beim Geräte- oder Chipkartenhersteller durchgeführt. Die Vorteile für den Geräte- oder Chipkartenhersteller liegen besonders in der Möglichkeit, Tests mit den Chips durchzuführen, solange sie auf dem Band fixiert sind.

Die Lieferform des Zulieferers besteht in diesem Fall entsprechend nach dem Schritt G. Insofern betrifft die Erfindung auch ein Verfahren zur Herstellung von Frames zur Aufnahme von Chips mit den Schritten A bis G.

Das erfindungsgemäße Verfahren wird anhand der Figuren wie folgt erläutert.
- Figur 1: zeigt einen IC-Frame.
- Figur 2: zeigt die aktuelle Situation beim Stanzverfahren des Standes der Technik.
- Figur 3: zeigt eine Ausführungsform mit Anbindungen über Kontaktflächen.

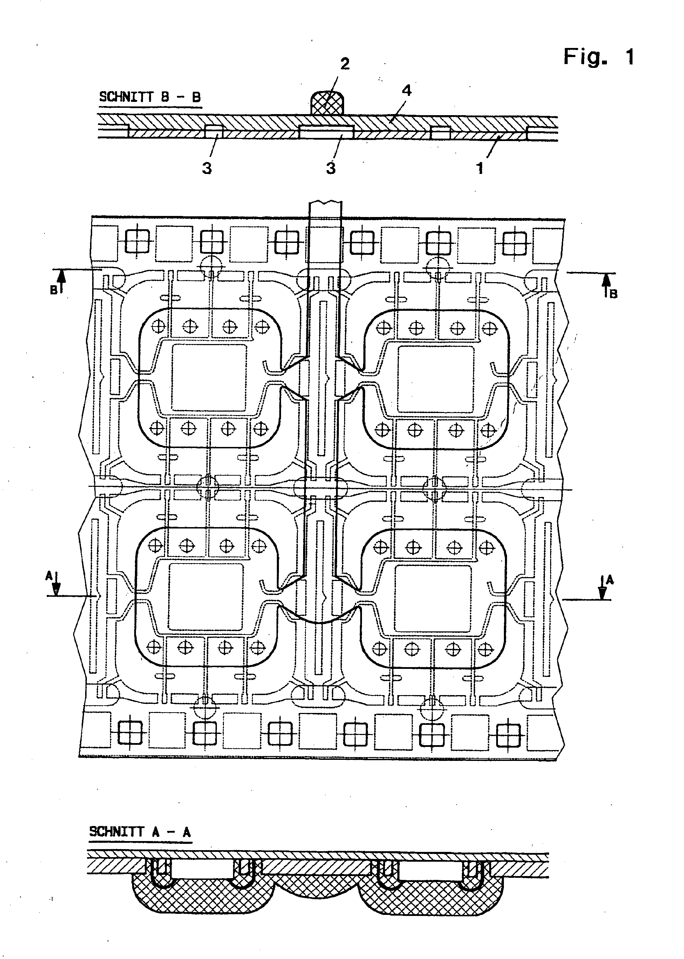

Die Folienverbundbänder werden Fräseinrichtung an den Metallkontaktstellen so durchtrennt, dass die gesamte Metallfolie durchtrennt wird. Zwangsläufig wird bei diesem Prozess ein geringfügiger Teil der Kunststofffolie angefräst. Die Gussmasse ist in der Mitte der Zeichnung in Figur 1 als vierblättrige Struktur mit durchgezogenen Linien dargestellt. Im Teilschnitt B-B sieht man die Kupferfolie 1, die durch gefräste Trennschlitze 3 unterbrochen ist. Die Fräsung erfasst einen Teil der Kunststofffolie 4. Die applizierte Gussmasse 2 ist in den Schnitten A-A und B-B durch Kreuzschraffur kenntlich gemacht. Man sieht in Fig. 1, dass die Trennschlitze 3 einen Teil der Kunststofffolie 4 mit erfassen.

Anschließend wird für gewöhnlich die Vergussmasse eingebracht. Die Vergussmasse 2 haftet glatt an der Folie, kann sich nicht verankern, und die überflüssigen Teile der Vergussmasse können problemlos abgetrennt werden.

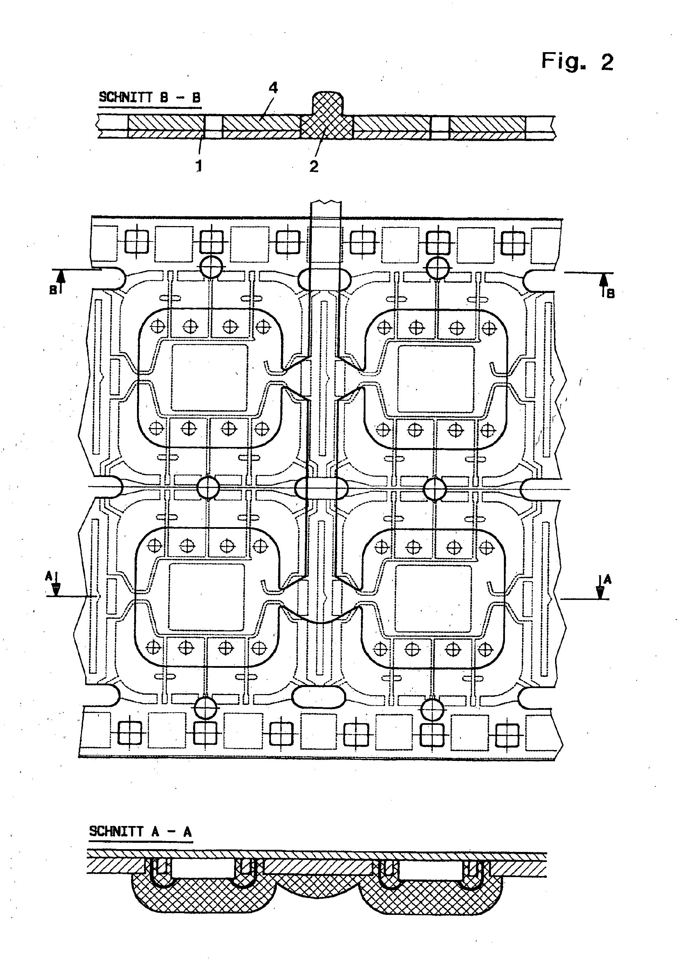

Dadurch, dass kein Stanzprozess erfolgt, kann sich keine Vergussmasse in den Löchern verankern. Dies bereitet beim herkömmlichen Verfahren Probleme. Figur 2 zeigt die Situation nach dem bisherigen Verfahren des Standes der Technik: Die Stanzungen umfassen Metallfolie 1 und Kunststofffolie 4. Im Schnitt B-B sieht man, dass die Gussmasse 2 (Kreuzschraffur) das Freistanzloch ausfüllt. Die Gussmasse hat Kontakt mit den durch das Stanzen eingebrachten Löchern der Folie und kann dadurch eine feste Haftung eingehen. Aus diesem Grund ist die Ablösung später schwierig.

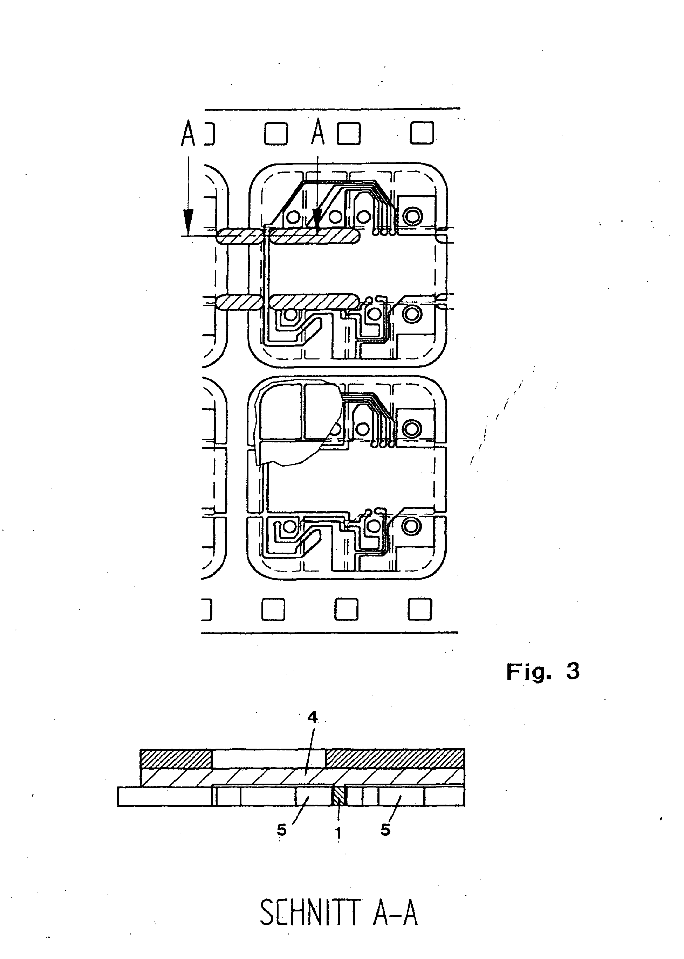

In Figur 3 ist eine weiter Ausführungsform mit Anbindungen über Kontaktflächen zu sehen. Im Schnitt A-A sieht man, dass die gefrästen Bereiche 5 einen Teil des Kunststoffes 4 mit erfassen.

In bevorzugten Ausführungsformen der Erfindung besitzt das Verfahren folgende zusätzliche Verfahrensschritte und/oder Merkmale:
- Die Trennung erfolgt im kontinuierlichen Verfahren auf dem Endlosband.
- Die Trennung erfolgt passgenau.
- Die Trennung erfolgt mit einem spanabhebenden Verfahren, insbesondere durch Fräsen oder Laserbehandlung.
- Der Verbund zwischen Metall und Kunststoff wird bei der Trennung nicht beschädigt oder aufgehoben.

Die Folienreste werden nach dem Trennen mit einem Saugverfahren entfernt.

## Patentansprüche

1. Verfahren zum Trennen der elektrischen Verbindungen bei auf langen Endlosbändern aus Kunststofffolie laminierten IC-Frames, **dadurch gekennzeichnet, dass** die Folienverbundbänder an den Metallkontaktstellen so durchtrennt werden, dass die Metallfolie in ihrer gesamten Stärke, nicht aber die Kunststofffolie durchtrennt wird.

2. Verfahren nach Anspruch 1, **dadurch gekennzeichnet, dass** die Trennung im kontinuierlichen Verfahren auf dem Endlosband erfolgt.

3. Verfahren nach Anspruch 1, **dadurch gekennzeichnet, dass** die Trennung selektiv bezüglich bestimmten elektrischen Verbindungen erfolgt

4. Verfahren nach Anspruch 1, **dadurch gekennzeichnet, dass** die Trennung passgenau erfolgt.

5. Verfahren nach Anspruch 1, **dadurch gekennzeichnet, dass** das Trennen mit einem spanabhebenden Verfahren erfolgt.

6. Verfahren nach Anspruch 1, **dadurch gekennzeichnet, dass** das Trennen durch Fräsen oder Laserbehandlung erfolgt.

7. Verfahren nach Anspruch 1, **dadurch gekennzeichnet, dass** der Verbund zwischen Metall und Kunststoff bei der Trennung nicht beschädigt oder aufgehoben wird.

8. Verfahren nach Anspruch 1, **dadurch gekennzeichnet, dass** die Folienreste nach dem Trennen mit einem Saugverfahren entfernt werden.

9. Verfahren zur Herstellung eines elektronischen Bauteils (Moduls) mit den Schritten:
A Bereitstellen einer Metallfolie;
B Stanzen der Metallfolie mit der Struktur des Systemträgers (Moduls);
C Bereitstellen einer Kunststoffolie;
D Passgenaues Stanzen der Kunststoff-Durchbrüche für die Bauteilmontage und Kontaktierung;
E Passgenaues Laminieren der gemäß B und D behandelten Metall und Kunststofffolie;
F Aufbringen von Funktionsschichten durch elektrogalvanisches Beschichten des Laminates;
G Selektives Trennen der elektrischen Verbindungen bei den auf langen Endlosbändern aus Kunststofffolie laminierten IC-Frames, wobei die Folienverbundbänder an den Metallkontaktstellen so durchtrennt werden, dass die Metallfolie in ihrer gesamten Stärke, nicht aber die Kunststofffolie durchtrennt wird;
H Positionieren eines Halbleiter Bauelementes (Chips) im Chip-Positivbereich, dem Durchbruch der Kunststoffolie;
I Verbinden der Kontaktflächen des Chips mit den Bondlöchern;
J Vergießen des Bauelements.

10. Verfahren nach Anspruch 9, wobei die Metallfolie in A in der Stärke 0,03 bis 0,2 mm vorliegt.

11. Verfahren nach Anspruch 9, wobei die Kunststofffolie in C in der Stärke 0,03 bis 0,2 mm vorliegt.

12. Verfahren zur Herstellung und Prüfung eines elektronischen Bauteils (Moduls) mit den Schritten A-J gemäß Anspruch 9 sowie dem Schritt
K Testen der elektronischen Funktion.

13. Verfahren zur Herstellung von Frames zur Aufnahme von Chips, bei dem die Schritte A bis G gemäß Anspruch 9 durchgeführt werden.
